# EUROPÄISCHE PATENTSCHRIFT

(11) **EP 0 359 060 B1**
(45) Veröffentlichungstag und Bekanntmachung des Hinweises auf die Patenterteilung: **09.11.1994**
(21) Anmeldenummer: 89116163.0
(22) Anmeldetag: 01.09.1989
(51) Int. Cl.: C08F 289/00, C08F 2/50, G03F 7/032

(54) **Photopolymerisierbares Gemisch, daraus hergestelltes Aufzeichnungsmaterial und Verfahren zur Herstellung von Kopien**
Photopolymerisable mixture, recording material manufactured therefrom and process for the production of copies
Mélange photopolymérisable, matériau d'enregistrement fabriqué à partir de celui-ci et procédé de production de copies

(30) Priorität: 10.09.1988 DE 3830914
(43) Veröffentlichungstag der Anmeldung: 21.03.1990
(73) Patentinhaber: HOECHST AKTIENGESELLSCHAFT, 65926 Frankfurt am Main (DE)
(72) Erfinder: Zertani, Rudolf, Dr., D-6500 Mainz-Laubenheim (DE); Mohr, Dieter, Dr., D-6501 Budenheim (DE); Rode, Klaus, Dr., CEP 08600-Suzano-SP (BR); Frass, Werner, Dr., D-6200 Wiesbaden-Naurod (DE); Joerg, Klaus, Dr., D-6507 Ingelheim (DE)

(56) Entgegenhaltungen:
- DE-A- 3 339 228
- PATENT ABSTRACTS OF JAPAN vol. 12, no. 5 (C-467)(2852) 8 Januar 1988,& JP-A-62 161868 (NORIKA AMANO) 17 Juli 1987,
- PLASDOC - CENTRAL PATENTS INDEX - BASIC ABSTRACTS JOURNAL, 20 Januar 1988,LONDON G; & JP-A-62 231 245

## Beschreibung

Die Erfindung betrifft ein photopolymerisierbares Gemisch, das als wesentliche Bestandteile
a) ein polymeres Bindemittel,
b) einen Acryl- oder Alkacrylsäureester eines mehrwertigen Alkohols und
c) einen Photoinitiator oder eine Photoinitiatorkombination
enthält, sowie ein entsprechendes Aufzeichnungsmaterial mit einem Schichtträger und einer photopolymerisierbaren Schicht, die aus dem Gemisch besteht.

Gemische und Materialien der vorstehend angegebenen Gattung sind bekannt und werden u. a. zur Herstellung von Druckplatten und Photoresists eingesetzt. Die Lichtempfindlichkeit der bekannten Gemische liegt im allgemeinen im nahen Ultraviolettbereich; sie wird durch den Zusatz von lichtabsorbierenden Substanzen, z. B. für die Herstellung von Zwischenoriginalen oder Farbprüffolien, stark herabgesetzt.

Als Kopiervorlagen werden in der Reproduktionstechnik zumeist solche auf Basis von Silberhalogenidmaterialien verwendet, die den Nachteil haben, sehr teuer zu sein.

Zum Duplizieren von Silberfilmoriginalen, z. B. Mikrofilmen, hat man deshalb lichtempfindliche Diazotypiematerialien eingesetzt, die zu gelb oder schwarz gefärbten Azofarbstoffen entwickelt werden. In der DE-B 1 286 897 wird ein derartiges Diazotypiematerial beschrieben, das zusätzlich UV-Absorber in der Schicht enthält. Nach diesem Verfahren läßt sich nur ein begrenzter Bildkontrast erreichen; auch neigen Filme auf Diazotypiebasis zur Verfärbung des Hintergrunds.

In der DE-A 15 72 085 wird ein lichtempfindliches Material zum Duplizieren von Silberbildern beschrieben, das eine lichtempfindliche Schicht aus o-Chinondiaziden und Farbpigmenten enthält, deren optische Dichte größer als 1 ist. Dieses Material, das in dem gleichen Spektralbereich absorbiert, in dem es lichtempfindlich ist, hat eine für die Praxis zu geringe Lichtempfindlichkeit.

In der US-A 3 218 167 wird ein photopolymerisierbares Aufzeichnungsmaterial beschrieben, dessen lichtempfindliche Schicht durch Farbstoffzusatz stark gefärbt ist. Der Farbstoff soll aber im Anregungsbereich des Photoinitiators möglichst wenig Licht absorbieren. Man erhält mit diesem Material Bilder mit gutem visuellem Kontrast, die aber als Kopiervorlagen nicht geeignet sind.

Ein ähnliches photopolymerisierbares Material, das durch unterschiedliche Haftung von belichteten und unbelichteten Schichtbereichen an einer Trägerfolie zum Bild entwickelt werden kann (peel-apart-Verfahren), ist in der US-A 3 353 955 beschrieben. Dieses Material weist eine auch im aktinischen Spektralbereich stark lichtabsorbierende Schicht auf. Diese Schicht wird aber wegen der stark verminderten Lichtempfindlichkeit nur in den oberen Schichtbereichen vollständig polymerisiert, während in den unteren Schichtbereichen die Bilddifferenzierung gering ist und zu einer Auswaschentwicklung nicht ausreicht. Die peel-apart-Entwicklung liefert jedoch nur Bilder mit relativ geringer Auflösung.

Es ist auch bekannt, aus photopolymerisierbaren Materialien Bilder mit hoher Lichtabsorption dadurch zu erhalten, daß man die unterschiedliche Klebrigkeit von belichteten und unbelichteten Bereichen ausnutzt und das belichtete Material, ggf. bei erhöhter Temperatur, mit einem Tonerpulver entwickelt. Dieses Verfahren wird in den US-A 3 060 024, 3 060 025 und 3 620 726 beschrieben. Auch dieses Verfahren liefert Bilder mit nur begrenzter Auflösung.

Auch Farbprüffolien werden nach Verfahren, wie sie vorstehend beschrieben sind, hergestellt und verarbeitet. Dabei erhält man eine originalgetreue Wiedergabe der Farbintensität meist nur durch Auswaschentwicklung mit Schichten, die durchgehend in dem gewünschten Farbton gefärbt sind. Jedenfalls bei den im kürzerwelligen Bereich des Spektrums absorbierenden Farben wird auch hier die Lichtempfindlichkeit sehr stark herabgesetzt.

In den älteren deutschen Patentanmeldungen P 37 10 279.6, P 37 10 281.8 und P 37 10 282.6 werden photopolymerisierbare Gemische vorgeschlagen, die polymere Bindemittel, polymerisierbare Acryl- oder Alkacrylsäureester, die photooxydierbare Gruppen aufweisen, und Photoinitiatoren oder Photoinitiatorkombinationen, insbesondere photoreduzierbare Farbstoffe und ggf. bestimmte lichtempfindliche Trichlormethylverbindungen sowie ggf. weitere radikalbildende Coinitiatoren enthalten. Diese Gemische zeichnen sich durch eine hohe Lichtempfindlichkeit, insbesondere im längerwelligen Bereich des sichtbaren Spektrums, d.h. oberhalb 450 nm aus. Der Zusatz von stark lichtabsorbierenden Substanzen, insbesondere von UV-Absorbern, zu diesen Gemischen wird in den älteren Anmeldungen nicht beschrieben.

Aufgabe der Erfindung ist es, ein photopolymerisierbares Gemisch und Aufzeichnungsmaterial vorzuschlagen, das sich durch Auswaschen zu Bildern mit hoher Absorption im aktinischen Spektralbereich unterhalb 450 nm entwickeln läßt und sich dennoch bei der Bildbelichtung durch eine hohe Lichtempfindlichkeit auszeichnet.

Die Erfindung geht aus von einem photopolymerisierbaren Gemisch, das als wesentliche Bestandteile
a) ein polymeres Bindemittel,
b) einen Acryl- oder Alkacrylsäureester eines mehrwertigen Alkohols, der mindestens eine photooxydierbare Gruppe enthält, und
c) eine Verbindung oder eine Verbindungskombination enthält, die unter Einwirkung von Licht im Spektralbereich von 450 bis 650 nm die Polymerisation der Verbindung (b) zu initiieren vermag.

Das erfindungsgemäße Gemisch ist dadurch gekennzeichnet, daß das Gemisch ferner mindestens eine Verbindung (d) enthält, die Licht im Bereich unterhalb 450 nm absorbiert oder die bei Belichtung in dem Gemisch eine Verbindung mit einer derartigen Lichtabsorption bildet, wobei die optische Dichte des belichteten Gemischs in diesem Bereich bei einer Schichtdicke von 2 µm mindestens 2,0 beträgt.

Erfindungsgemäß wird ferner ein photopolymerisierbares Aufzeichnungsmaterial mit einem Schichtträger und einer photopolymerisierbaren Schicht vorgeschlagen, das dadurch gekennzeichnet ist, daß die photopolymerisierbare Schicht aus einem Gemisch der vorstehend angegebenen Zusammensetzung besteht.

Erfindungsgemäß wird weiterhin ein Verfahren zur Herstellung von Kopien mittels des vorstehend beschriebenen Aufzeichnungsmaterials vorgeschlagen, das darin besteht, daß man die photopolymerisierbare Schicht mit Licht einer Wellenlänge oberhalb 450 nm bildmäßig belichtet, die Nichtbildstellen mit einem Entwickler auswäscht und das erhaltene Negativbild als Kopiervorlage für die Belichtung einer lichtempfindlichen Schicht mit Licht im Spektralbereich unterhalb 450 nm einsetzt.

Gemäß einer anderen Ausführungsformm des erfindungsgemäßen Verfahrens wird ein Farbprüfverfahren für den Mehrfarbendruck vorgeschlagen, bei dem man
A) die photopolymerisierbare Schicht eines lichtempfindlichen Aufzeichnungsmaterials der vorstehend beschriebenen Art, das einen transparenten, vorzugsweise flexiblen temporären Schichtträger mit einer zusätzlichen lichtempfindlichen Schicht auf seiner Rückseite aufweist, die für Licht im Spektralbereich unterhalb 450 nm empfindlich ist, einen Farbstoff oder ein Pigment in einer Grundfarbe des Mehrfarbendrucks enthält und von dem temporären Schichtträger auf ein Empfangsblatt übertragbar ist, bildmäßig mit Licht einer Wellenlänge oberhalb 450 nm bildmäßig belichtet,
B) vor oder nach dem Belichten das Material mit der zusätzlichen lichtempfindlichen Schicht auf ein Empfangsblatt laminiert,
C) die unbelichteten Bereiche der photopolymerisierbaren Schicht auswäscht,
D) die zusätzliche lichtempfindliche Schicht durch den transparenten Schichtträger hindurch unter der entwickelten photopolymerisierbaren Schicht als Kopiervorlage mit Licht einer Wellenlänge unterhalb 450 nm belichtet,
E) den Schichtträger mit der entwickelten photopolymerisierbaren Schicht von der zusätzlichen lichtempfindlichen Schicht abzieht,
F) die letztere durch Auswaschen der Nichtbildstellen entwickelt
und die Schritte (A) bis (F) mit mindestens einem lichtempfindlichen Aufzeichnungsmaterial, dessen zusätzliche lichtempfindliche Schicht in einer anderen Grundfarbe eingefärbt ist, wiederholt.

Das erfindungsgemäße Aufzeichnungsmaterial kann in verschiedenen Ausführungsformen vorliegen.

Das photopolymerisierbare Gemisch kann auf einen transparenten Schichtträger aufgebracht werden und zur Herstellung von Kopiervorlagen für Materialien verwendet werden, die im Spektralbereich unterhalb 450 nm empfindlich sind.

Es kann ferner als zusätzliche lichtempfindliche Schicht auf ein Material mit UV-empfindlicher Schicht aufgebracht werden. Die photopolymerisierbare Schicht der erfindungsgemäßen Zusammensetzung wird mit sichtbarem Licht bei Wellenlängen oberhalb 450 nm, insbesondere bei 450 bis 650 nm belichtet und dann entwickelt. Die erhaltene bildmäßig entwickelte Schicht dient als Belichtungsschablone für die nachfolgende Belichtung der UV-empfindlichen Schicht mit Licht unterhalb 450 nm, die dann ohne Vorlage erfolgt. Wenn der Schichtträger lichtundurchlässig ist, muß die Schicht aus dem erfindungsgemäßen Gemisch auf die erste lichtempfindliche Schicht aufgebracht werden. Wenn der Schichtträger transparent ist, kann das erfindungsgemäße Gemisch auch auf die Rückseite des Trägers aufgebracht werden. In diesem Fall kann die UV-empfindliche Schicht ggf. vor oder nach dem Entwickeln auf einen permanenten Schichtträger durch Laminieren übertragen werden. Auf diese Weise kann im Rahmen eines Farbprüfverfahrens stufenweise ein Mehrfarben-Prüfbild auf dem permanenten Schichtträger aufgebaut werden.

Die Schichten aus dem erfindungsgemäßen photopolymerisierbaren Gemisch haben im allgemeinen eine Dicke von etwa 0,5 bis 10, vorzugsweise 1 bis 6 µm. Ihre optische Dichte sollte bei einer Dicke von 2 µm mindestens 2 betragen; bei dünneren Schichten ist die Konzentration an UV-absorbierender Verbindung so weit zu erhöhen, daß die optische Dichte der Schicht nicht kleiner als 2 wird. Die Schichten zeichnen sich durch eine hohe Lichtempfindlichkeit im sichtbaren Spektralbereich, insbesondere bei 450 bis 650 nm aus und haben in diesem Bereich zur vollständigen Durchhärtung einen Energiebedarf von nicht mehr als 10 mJ/cm².

Die Bestandteile (a), (b) und (c) der erfindungsgemäßen Gemische sind in den oben genannten älteren Patentanmeldungen und in den weiteren älteren Patentanmeldungen P 37 38 864.9 und P 38 24 903.0 ausführlich beschrieben.

Für die Zwecke der Erfindung geeignete polymerisierbare Verbindungen (b) sind Acryl- und Alkacrylsäureester von ein- oder mehrwertigen Alkoholen, die mindestens eine photooxydierbare und gegebenenfalls mindestens eine Urethangruppe im Molekül enthalten.

Als photooxydierbare Gruppen kommen insbesondere Aminogruppen, Harnstoffgruppen, Thiogruppen, die auch Bestandteile heterocyclischer Ringe sein können, und Enolgruppen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Beispiele für Verbindungen mit photooxydierbaren Gruppen sind Acryl- und Alkacrylsäureester der Formel I 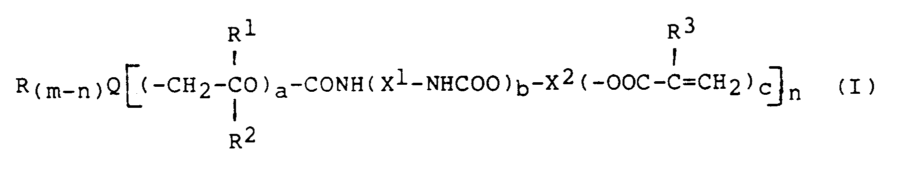
worin
- Q: -Ń-, -Ń-E-Ń-, 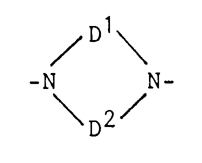 oder -S-
- R: eine Alkyl-, Hydroxyalkyl- oder Arylgruppe,
- R¹ und R²: jeweils ein Wasserstoffatom, eine Alkylgruppe oder Alkoxyalkylgruppe,
- R³: ein Wasserstoffatom, eine Methyl- oder Ethylgruppe,
- X¹: eine gesättigte Kohlenwasserstoffgruppe mit 2 bis 12 Kohlenstoffatomen,
- X²: eine (c+1)-wertige gesättigte Kohlenwasserstoffgruppe, in der bis zu 5 Methylengruppen durch Sauerstoffatome ersetzt sein können,
- D¹ und D²: jeweils eine gesättigte Kohlenwasserstoffgruppe mit 1 bis 5 Kohlenstoffatomen,
- E: eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern,
- a: 0 oder eine ganze Zahl von 1 bis 4,
- b: 0 oder 1,
- c: eine ganze Zahl von 1 bis 3,
- m: je nach Wertigkeit von Q 2, 3 oder 4 und
- n: eine ganze Zahl von 1 bis m
bedeutet, wobei alle Symbole gleicher Definition untereinander gleich oder verschieden sein können.

Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Im allgemeinen ist in nicht mehr als einem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatomen substituiert sein.

Wenn R¹ und R² Alkyl- oder Alkoxyalkylgruppen sind, können diese 1 bis 5 Kohlenstoffatome enthalten.

R³ ist bevorzugt ein Wasserstoffatom oder eine Methylgruppe, insbesondere eine Methylgruppe.

X¹ ist bevorzugt ein geradkettiger oder verzweigter aliphatischer oder cycloaliphatischer Rest mit vorzugsweise 4 bis 10 Kohlenstoffatomen.

X² hat vorzugsweise 2 bis 15 Kohlenstoffatome, von denen bis zu 5 durch Sauerstoffatome ersetzt sein können. Wenn es sich µm reine Kohlenstoffketten handelt, werden im allgemeinen solche mit 2 bis 12, vorzugsweise 2 bis 6 Kohlenstoffatomen eingesetzt. X² kann auch eine cycloaliphatische Gruppe mit 5 bis 10 Kohlenstoffatomen, insbesondere eine Cyclohexylengruppe sein.

D¹ und D² können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

Der Wert von c ist vorzugsweise 1.

Die polymerisierbaren Verbindungen der Formel I, die zwei Urethangruppen in jedem Rest (b = 1) enthalten, werden dargestellt, indem Acryl- oder Alkylacrylsäureester, die freie Hydroxygruppen enthalten, in bekannter Weise mit der gleichen Molmenge an Diisocyanaten umgesetzt werden und die überschüssige Isocyanatgruppe mit Hydroxyalkylaminen, N,N-Bis-hydroxyalkyl-piperazinen oder N,N,N′,N′-Tetra-hydroxyalkyl-alkylendiaminen, umgesetzt wird, wobei einzelne Hydroxyalkylgruppen durch Alkyl- oder Arylgruppen R ersetzt sein können. Wenn a = 0 ist, entsteht eine Harnstoffgruppierung.

Beispiele für die als Ausgangsstoffe verwendeten Hydroxyalkylamine sind Triethanolamin, N-Alkyl-N,N-di(hydroxyalkyl)amine, Diethanolamin, Tris-(2-hydroxypropyl)amin oder Tris-(2-hydroxybutyl)amin.

Beispiele für die als Ausgangsstoffe verwendeten Diisocyanate sind Hexamethylendiisocyanat, 2,2,4-Trimethylhexamethylendiisocyanat, 1,4-Cyclohexylendiisocyanat und 1,1,3-Trimethyl-3-isocyanatomethyl-5-isocyanatocyclohexan.

Als Hydroxygruppen enthaltende Ester werden insbesondere Hydroxyethylmethacrylat und Hydroxypropylmethacrylat (n oder iso) sowie die entsprechenden Acrylate verwendet.

Die polymerisierbaren Verbindungen der Formel I mit b = 0 werden dargestellt, indem die oben beschriebenen Hydroxyalkylaminoverbindungen mit Isocyanatgruppen enthaltenden Acryl- oder Alkylacrylsäureestern umgesetzt werden. Als Isocyanatgruppen enthaltender Ester wird insbesondere Isocyanatoethyl(meth)acrylat eingesetzt.

Weitere geeignete Verbindungen mit photooxydierbaren Gruppen sind Verbindungen der Formel II 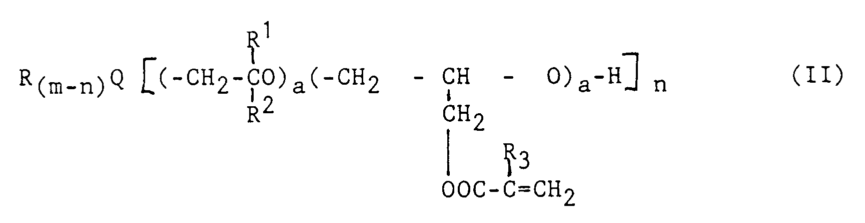
worin Q, R, R¹, R², R³, a, m und n die oben angegebene Bedeutung haben und Q zusätzlich eine Gruppe 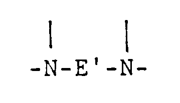
sein kann, worin E' eine Gruppe der Formel III 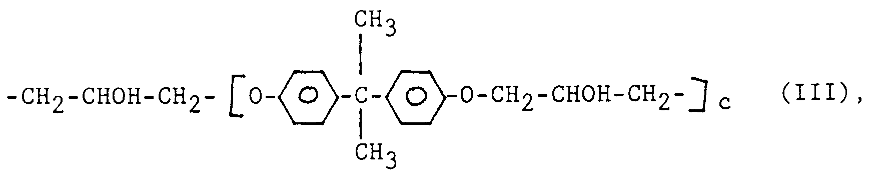
ist.

Die Herstellung der Verbindungen der Formel II erfolgt analog derjenigen der Formel I, wobei anstelle von Hydroxyalkyl(alk)acrylaten die entsprechenden (Alk)acrylsäureglycidylester eingesetzt werden.

Weitere geeignete Verbindungen mit photooxydierbaren Gruppen sind Acryl- und Alkacrylsäureester der Formel IV 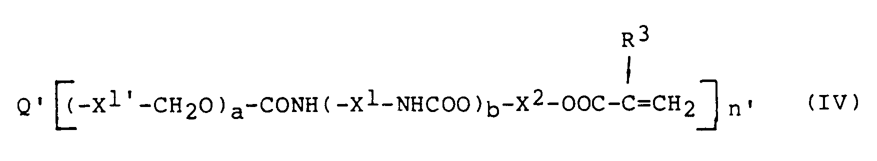
worin
- Q′: 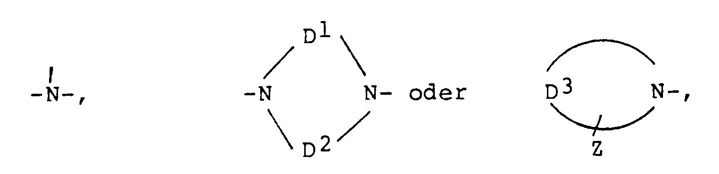
- X^{1′}: CᵢH₂ᵢ oder 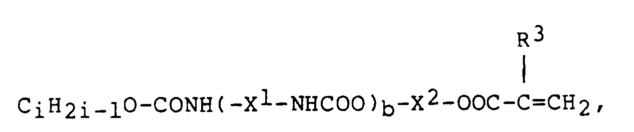
- D³: eine gesättigte Kohlenwasserstoffgruppe mit 4 bis 8 Kohlenstoffatomen, die mit dem Stickstoffatom einen 5- oder 6-gliedrigen Ring bildet,
- Z: ein Wasserstoffatom oder einen Rest der Formel 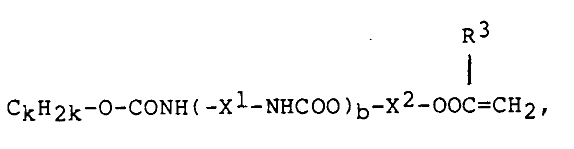
- i und k: ganze Zahlen von 1 bis 12,
- n: ′ je nach Wertigkeit von Q′ 1, 2 oder 3
bedeutet, und R³, X¹, X², D¹, D², a und b die bei Formel I angegebene Bedeutung haben, wobei alle Symbole gleicher Definition untereinander gleich oder verschieden sein können und wobei in mindestens einem Substituenten an der Gruppe Q′a = O ist.

Von den Verbindungen der Formel IV werden solche bevorzugt, die außer einer Harnstoffgruppe mindestens eine Urethangruppe enthalten. Als Harnstoffgruppen sollen Gruppen der Formel

〉N - CO - N〈

angesehen werden, bei denen die Valenzen am Stickstoff mit ggf. substituierten Kohlenwasserstoffresten abgesättigt sind. Es kann aber auch eine Valenz an einem Stickstoffatom an eine weitere Carbonylamidgruppe (CONH) gebunden sein, so daß eine Biuretstruktur entsteht.

Das Symbol a ist in Formel IV vorzugsweise 0 oder 1; i ist vorzugsweise eine Zahl von 2 bis 10.

Die polymerisierbaren Verbindungen der Formel IV werden analog zu den Verbindungen der Formel I hergestellt.

Neben den polymerisierbaren Verbindungen mit photooxydierbaren Gruppen können auch kleinere Mengenanteile herkömmlicher Monomerer eingesetzt werden. Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen oder N-substituierte Acryl-und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben.
Der Mengenanteil des photopolymerisierbaren Gemischs an polymerisierbaren Verbindungen beträgt im allgemeinen etwa 10 bis 75, bevorzugt 20 bis 60 Gew.-%, bezogen auf die nichtflüchtigen Bestandteile.

Beispiele für verwendbare Bindemittel (a) sind chloriertes Polyethylen, chloriertes Polypropylen, Poly(meth)acrylsäurealkylester, bei denen die Alkylgruppe z. B. Methyl, Ethyl, n-Butyl, i-Butyl, n-Hexyl oder 2-Ethylhexyl ist, Copolymere der genannten (Meth)acrylsäurealkylester mit mindestens einem Monomeren, wie Acrylnitril, Vinylchlorid, Vinylidenchlorid, Styrol oder Butadien; Polyvinylchlorid, Vinylchlorid/Acrylnitril-Copolymere, Polyvinylidenchlorid, Vinylidenchlorid/Acrylnitril-Copolymere, Polyvinylacetat, Polyvinylalkohol, Polyacrylnitril, Acrylnitril/Styrol-Copolymere, Acrylnitril/Butadien/Styrol-Copolymere, Polystyrol, Polymethylstyrol, Polyamide (z. B. Nylon-6), Polyurethane, Methylcellulose, Ethylcellulose, Acetylcellulose, Polyvinylformal und Polyvinylbutyral.

Besonders geeignet sind Bindemittel, die in Wasser unlöslich, in organischen Lösemitteln löslich und in wäßrig-alkalischen Lösungen löslich oder zumindest quellbar sind.

Besonders erwähnt werden sollen Carboxylgruppen enthaltende Bindemittel, z. B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin sind geeignet Umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen, insbesondere Formaldehyd, Acetaldehyd oder Aceton, mit Phenolen oder Copolymerisate der Hydroxystyrole. Schließlich lassen sich auch Copolymerisate des (Meth)acrylsäureamids mit Alkyl(meth)acrylaten verwenden.

Die vorstehend beschriebenen Polymeren sind insbesondere dann geeignet, wenn sie ein Molekulargewicht zwischen 500 und 200 000 oder darüber, bevorzugt 1 000 bis 100 000 aufweisen und entweder Säurezahlen zwischen 10 und 250, bevorzugt von 20 bis 200, oder Hydroxylzahlen zwischen 50 und 750, bevorzugt von 100 bis 500, aufweisen.

Als bevorzugte alkalilösliche Bindemittel seien nachstehend erwähnt:
Copolymerisate der (Meth)acrylsäure mit Alkyl(meth)acrylaten, (Meth)acrylsäurenitril oder dergleichen, Copolymerisate der Crotonsäure mit Alkyl(meth)acrylaten, (Meth)acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäureanhydrids, Veresterungsprodukte von Hydroxylgruppen enthaltenden Polymeren mit Anhydriden von Di- oder Polycarbonsäuren, Copolymerisate der Hydroxyalkyl(meth)acrylate mit Alkyl(meth)acrylaten, (Meth)acrylsäurenitril oder dergleichen, Copolymerisate des Allylalkohols mit ggf. substituierten Styrolen, Copolymerisate des Vinylalkohols mit Alkyl(meth)acrylaten oder anderen polymerisationsfähigen ungesättigten Verbindungen, Polyurethane, sofern sie eine ausreichende Anzahl freier OH-Gruppen aufweisen, Epoxyharze, Polyester, teilverseifte Vinylacetat-Copolymere, Polyvinylacetale mit freien OH-Gruppen, Copolymerisate der Hydroxystyrole mit Alkyl(meth)acrylaten oder dergleichen, Phenol-Formaldehyd-Harze, z. B. Novolake.

Die Menge des Bindemittels in der lichtempfindlichen Schicht beträgt im allgemeinen 20 bis 85, vorzugsweise 40 bis 75 Gew.-%.

Als Photoinitiatoren (c) können eine Vielzahl von Substanzen Verwendung finden. Beispiele sind solche, die sich vom Grundkörper der Benzophenone, Acetophenone, Benzoine, Benzile, Benzilmonoketale, des Fluorenons, Thioxanthons, der Mehrkernchinone, Acridine und Chinazoline ableiten; ferner Trichlormethyl-s-triazine, 2-Halogenmethyl-5-vinyl-1,3,4-oxadiazolderivate, mit Trichlormethylgruppen substituierte Halogenoxazole oder Trihalogenmethylgruppen enthaltende Carbonylmethylenheterocyclen, wie sie in der DE-A 33 33 450 angegeben sind.

Bevorzugt werden als Photoinitiatoren photoreduzierbare Farbstoffe, insbesondere in Kombination mit durch Belichtung spaltbaren Trihalogenmethylverbindungen und gegebenenfalls mit als Photoinitiatoren wirksamen Acridin-, Phenazin- oder Chinoxalinverbindungen.

Geeignete photoreduzierbare Farbstoffe sind insbesondere Xanthen-, Benzoxanthen-, Benzothioxanthen-, Thiazin-, Pyronin, Porphyrin- oder Acridinfarbstoffe. Die Menge des Farbstoffs liegt im allgemeinen zwischen 0,01 und 10, vorzugsweise zwischen 0,05 und 4 Gew.-%, bezogen auf die nichtflüchtigen Bestandteile der Schicht.

Zur Steigerung der Lichtempfindlichkeit können den Schichten Verbindungen mit photolytisch spaltbaren Trihalogenmethylgruppen, die als radikalbildende Photoinitiatoren für photopolymerisierbare Gemische an sich bekannt sind, zugesetzt werden. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137 452, der DE-A 27 18 259 und der DE-A 22 43 621 beschrieben sind. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyl-tribrommethylsulfon, sind geeignet.

Diese Komponenten werden im allgemeinen in einer Menge von 0,01 bis 10, vorzugsweise von 0,05 bis 6 Gew.-%, bezogen auf die nichtflüchtigen Bestandteile der Schicht, eingesetzt.

Die erfindungsgemäßen Materialien enthalten vorzugsweise als weiteren Initiatorbestandteil eine Acridin-, Phenazin- oder Chinoxalinverbindung. Diese Verbindungen sind als Photoinitiatoren bekannt und in den DE-C 20 27 467 und 20 39 861 beschrieben. Die Menge dieser Komponente liegt ebenfalls im Bereich von 0,01 bis 10 Gew.-%, vorzugsweise zwischen 0,05 und 5 Gew.%.

Wenn eine weitere Empfindlichkeitssteigerung im sichtbaren Spektralbereich erwünscht ist, kann diese durch Zusatz einer Verbindung vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Die Menge dieser Verbindung liegt ebenfalls im Bereich von 0,01 bis 10, vorzugsweise von 0,05 bis 4 Gew.-%.

Die Gesamtmenge an Polymerisationsinitiatoren liegt im allgemeinen bei 0,05 bis 20, vorzugsweise bei 0,1 bis 10 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger.

Die optische Dichte der photopolymerisierbaren Gemische läßt sich mit Hilfe von geeigneten lichtabsorbierenden Substanzen (d) einstellen. Hierzu gehören Farbstoffe, Pigmente, UV-Absorber und UV-Farbstoffe, die in der Lage sind, die damit versetzte Schicht gegen die Einwirkung von UV-Licht undurchlässig zu machen. Ihr Mengenanteil beträgt im allgemeinen 5 bis 40, vorzugsweise 10 bis 30 Gew.-%.

Die nachstehenden Beispiele für UV-Absorptionsmittel und UV-Farbstoffe können den beschriebenen photopolymerisierbaren Gemischen zugesetzt werden:
2,2′-Dihydroxy-4-methoxybenzophenon, 4-Dodecyloxy-2-hydroxy-benzophenon, 2,4-Dihydroxybenzophenon, Hydroxyphenyl-benzotriazol, Resorcinmonobenzoat, Oil-Orange (C.I. 12055), Sudan-Orange RA (C.I. 12055), Capracyl-Orange (C.I. 60), Sudangelb (C.I. 30), Siriuslichtgelb R extra (C.I. 29025), Remazolbrillantorange RR (C.I. 17756), Remazolbrillantorange 3R (C.I. 17757) Remazolgoldgelb G (C.I. 18852), Remazolgelb RTL (Reactive Yellow 24), Echtlichtgelb 3G (C.I. 19120), Astrazongelb 3G (C.I. 48055), Astrazongelb 5G (C.I. 48065) oder Basic Yellow 52115 (C.I. 48060), und weiterhin kommen die noch nicht klassifizierten Farbstoffe Astrazonorange 3R, Astrazongelb 7 GLL, Astrazongelb GRL und Astragelb R in Frage. Als besonders geeignet erweisen sich Astrazonorange R (C.I. 48040) und Astrazonorange G (C.I. 48035). Geeignet sind auch Pigmentfarbstoffe, bzw. Pigmentpräparationen, z.B. Permanentrot FGR (C.I. 12370), Permanentcarmin FBB (C.I. 12485), Hostapermblau B2G (C.I. 74160), Renolschwarz G (C.I. 30235). Weiterhin läßt sich die optische Dichte der Schicht mit Hilfe geeigneter Verfärbungsmittel einstellen, welche ursprünglich farblos sind. Diese werden durch die Einwirkung des Photozersetzungsproduktes des Mittels zur Erzeugung der freien Radikale gefärbt. Typische Beispiele sind Arylamine. Zu diesem Zweck geeignet sind nicht nur einfache Arylamine, wie primäre, sekundäre und tertiäre aromatische Amine, sondern auch Leukofarbstoffe. Für die Praxis geeignete Beispiele umfassen Diphenylamin, Dibenzylanilin, Triphenylamin, Diethylanilin, Diphenyl-p-phenylendiamin, p-Toluidin, Leukomalachitgrün, Leukokristallviolett, 4,4′-Bis-dimethylamino-diphenylmethylimin, 4,4′,4˝-Tris-dipropylamino-triphenylmethan. Außerdem sind z.B. Oxdiazolderivate gemäß DE-A 10 58 836, 6-Phenyl-α-Pyrone (DE-A 16 68 358), 4,4′-Dibenzalacetone, wie 4-Diethylamino-4′-methoxydibenzalaceton, und Cumarinderivate wie 3-Acetyl-7-diethylamino-cumarin sehr gut geeignet.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw.. Solche Deckschichten haben im allgemeinen eine Dicke von 0,1 bis 10, vorzugsweise 1 bis 5 µm.

Als Schichtträger für mit dem erfindungsgemäßen Gemisch hergestellte Aufzeichnungsmaterialien sind beispielsweise Aluminium, Stahl, Zink, Kupfer und Kunststoff-Folien, z. B. aus Polyethylenterephthalat oder Celluloseacetat, transparente Papiere oder Glasplatten geeignet. Als transparente Schichtträger werden biaxial verstreckte Polyesterfolien bevorzugt, insbesondere aus Polyethylenterephthalat, die normalerweise eine Dicke von etwa 25 bis 250 µm aufweisen, vorzugsweise in glasklarer Photoqualität. Die photopolymerisierbaren Schichten, die im allgemeinen 0,5 bis 10 µm dick sind, haften darauf auch ohne eine Vorbehandlung mit Haftvermittlern und zeigen auch nach dem Entwickeln eine gute Haftung. Eine weitere Verbesserung der Haftung der lichtempfindlichen Schicht läßt sich gewünschtenfalls durch eine ein- oder beidseitig aufgebrachte Haftvermittlerschicht erzielen. Hierfür kommen Terpolymere aus Vinylidenchlorid, Acrylestern und Itaconsäure (US-A 2 627 088 und 2 698 240) in Betracht. Als weitere Haftvermittler sind die thermofixierten Acrylat- oder Methacrylatbeschichtungen gemäß US-A 3 819 773 geeignet, die aus wäßrigem Medium auf Polyesterfolie aufgebracht werden können und die Haftung von darauf aus organischen Lösemitteln aufgebrachten reprographischen Schichten verbessern. Ebenfalls brauchbar ist eine Haftvermittlerbeschichtung aus vernetzten Vinylacetatpolymeren gemäß EP-A 0 146 066.

Das erfindungsgemäße Verfahren umfaßt verschiedene Ausführungsformen, die für unterschiedliche Anwendungszwecke und Anwendungsgebiete bestimmt und geeignet sind. Wenn das erfindungsgemäße photopolymerisierbare Gemisch als einzige lichtempfindliche Schicht auf einen transparenten Schichtträger aufgebracht wird, ist das erhaltene Material als Duplizierfilm oder als laserbebilderbares Material geeignet, das als solches zur Informationsspeicherung oder als Maske für die Kontaktbelichtung von üblichen, gegen UV-Licht empfindlichen Aufzeichnungsmaterialien geeignet ist.

Eine andere Ausführungsform eignet sich zur Herstellung üblicher reprographischer Materialien, wie Druckplatten oder Photoresistmaterialien, sowohl auf transparenten als auch auf lichtundurchlässigen Trägern.

Hierbei wird das photopolymerisierbare Gemisch direkt auf eine UV-empfindliche positiv oder negativ arbeitende Schicht aufgebracht, ohne daß eine Vermischung der Schichten auftritt. Dies kann durch die Verwendung unterschiedlicher Bindemittel und Lösemittel oder durch Laminieren der auf einem getrennten temporären Träger hergestellten Photopolymerschicht erreicht werden. Nach der bildmäßigen Belichtung werden die unbelichteten Schichtbereiche in einem Entwicklungsschritt abgelöst, und die zurückbleibenden UV-undurchlässigen, gehärteten Bildanteile dienen als Bildmaske in einer zweiten Belichtung mit UV-Licht für die UV-empfindliche positiv oder negativ arbeitende Schicht. Bei geeigneter Kombination der Schichten gelingt es, die unter den durchgehärteten Bildanteilen liegende Schicht gegen eine Entwicklung so zu schützen, daß in einem einzigen Entwicklungsschritt ein sauber entwickeltes Bild entsteht.

Eine weitere Ausführungsform eignet sich bevorzugt zur Herstellung von laserbebilderbaren Farbprüffolien. In diesem Fall wird die photopolymerisierbare Masse auf die unbeschichtete Seite von negativ bzw. positiv arbeitenden Farbprüffolien, wie sie z. B. in den EP-A 182 031 und 179 274 beschrieben sind, in den vier Grundfarben Blaugrün, Gelb, Purpur und Schwarz zur Herstellung von Bildmasken aufgebracht. Die UV-empfindliche Seite, welche mit einer Haft- bzw. Klebeschicht versehen ist, wird auf ein Empfangsblatt laminiert. Nach einer anschließenden bildmäßigen Belichtung der im Sichtbaren empfindlichen, photopolymerisierbaren Schicht, die in dem Schichtverbund nun die oberste Schicht bildet, und anschließender Entwicklung erhält man eine Bildmaske, die gegenüber UV-Licht eine genügend hohe optische Dichte aufweist. Die zweite, UV-lichtempfindliche Schicht wird bildmäßig durch eine Belichtung ohne Vorlage differenziert, die temporäre Trägerfolie abgezogen und die darunterliegende positiv oder negativ arbeitende Schicht entwickelt. Die Haftschicht wird durch die Entwicklung nicht angegriffen. Bei diesem Verfahren erweist es sich als günstig, daß die hochlichtempfindliche, UV-Licht absorbierende Schicht nach der zweiten Belichtung abgezogen wird und somit der Farbeindruck des fertigen Farbbildes nicht verfälscht wird. Durch Aufeinanderlaminieren der Teilfarbenbilder mit den Farben Gelb, Blaugrün, Purpur und Schwarz erhält man ein Vierfarbenbild, das eine genaue Wiedergabe des Originals ist, von dem die Farbauszüge hergestellt wurden.

Die nutzbare Lichtempfindlichkeit der erfindungsgemäßen Materialien reicht von etwa 450 bis 800, insbesondere von 450 bis 650 nm und umspannt somit einen sehr breiten Bereich. Als Lichtquellen kommen daher eine große Anzahl der verschiedensten Typen zur Anwendung. Es sind sowohl Punkt-Lichtquellen als auch flächenförmige Strahler geeignet. Beispiele sind: Kohlenbogenlampen, Xenonbogenlampen, Quecksilberdampflampen, gegebenenfalls mit Metallhalogeniden dotiert, Fluoreszenzlampen mit Leuchtstoffen, die UV-Strahlung emittieren, Argonglühlampen, Elektronenblitzlampen, photographische Flutlichtlampen und Wolfram-Quarz-Jod-Lampen.

Speziell geeignet sind Laserlichtquellen, z.B. Argonionenlaser oder Kryptonionenlaser mit starken Emissionslinien (Ar-Laser) bei 457, 476, 488, 514, 528 nm. Bei dieser Art der bildmäßigen Belichtung ist keine Photomaske im Kontakt mit der Photopolymerschicht nötig; der gesteuerte Laserstrahl schreibt direkt auf die Schicht. Hier ist die hohe Empfindlichkeit der erfindungsgemäßen Materialien sehr vorteilhaft.

Das erfindungsgemäße Verfahren erlaubt es, Kopiervorlagen verschiedenster Art mit hohem Bildkontrast im nahen Ultraviolettbereich, d. h. bei Wellenlängen unterhalb etwa 450 nm herzustellen. Wenn Schichten aus dem erfindungsgemäßen Gemisch zusätzlich auf bekannte reprographische Materialien aufgebracht werden, kann man dadurch den Energiebedarf für die bildmäßige Belichtung wesentlich herabsetzen. Durch bildmäßige Belichtung der hochlichtempfindlichen photopolymerisierbaren Schicht gemäß der Erfindung mit sichtbarem Licht erhält man in situ gut abdeckende Belichtungsschablonen für die wenig empfindliche Schicht. Diese kann dann ohne zusätzliche Vorlage durch Bestrahlung mit UV-Licht relativ schnell und leicht belichtet werden. Gegebenenfalls kann die UV-absorbierende Belichtungsschablone nachträglich, z. B. durch Abziehen der zugehörigen Trägerfolie bei dem beschriebenen Farbprüfverfahren oder durch Ablösen mit einem selektiven Lösemittel oder beim Entwickeln einer darunterliegenden Negativschicht zusammen mit deren unbelichteten, abgedeckten Schichtbereichen, entfernt werden.

Die Verarbeitung der belichteten photopolymerisierbaren Schichten gemäß der Erfindung wird in bekannter Weise vorgenommen. Zur besseren Vernetzung der Schicht kann eine Nacherwärmung nach dem Belichten erfolgen. Zur Entwicklung wird sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf der Unterlage zurückbleiben. Die Entwicklerlösungen können einen kleinen Anteil, vorzugsweise weniger als 5 Gew.-%, an mit Wasser mischbaren organischen Lösemitteln enthalten. Sie können ferner Netzmittel, Farbstoffe, Salze und andere Zusätze enthalten.

Im folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

### Beispiel 1

Als Schichtträger wurden biaxial verstreckte 35 µm dicke Polyethylenterephthalatfolien verwendet. Die Träger wurden mit einer Lösung folgender Zusammensetzung überzogen:
2,87 Gt einer 34,8 %igen Lösung eines Terpolymerisats aus Styrol, n-Hexylmethacrylat und Methacrylsäure (10:60:30) mit der Säurezahl 190 in Butanon,
4,5 Gt einer 31 %igen Lösung des Umsetzungsprodukts von Triethanolamin mit 3 mol Isocyanatoethylmethacrylat in Butanon,
0,04 Gt Eosin alkohollöslich (C.I. 45 386),
0,03 Gt 2,4-Bis-trichlormethyl-6-(4-styryl-phenyl)-s-triazin,
0,06 Gt 9-Phenylacridin,
0,2 Gt 2,5-Bis-(4-diethylamino-phenyl)-1,3,4-oxdiazol und
0,2 Gt 4-Dimethylamino-4′-methoxy-dibenzalaceton in
20 Gt Propylenglykolmonomethylether.

Das Auftragen erfolgte durch Aufschleudern zu unterschiedlichen Schichtdicken, so daß Trockengewichte von 2,0 bis 3,2 g/m² erhalten wurden. Anschließend wurden die Folien zwei Minuten bei 100°C im Umlufttrockenschrank getrocknet. Die Folien wurden dann mit einer 15 %igen wäßrigen Lösung von Polyvinylalkohol (12 % Restacetylgruppen, K-Wert 4) beschichtet. Nach dem Trocknen wurden Deckschichten mit einem Gewicht von etwa 2,5 g/m² erhalten. Die erhaltenen Folien wurden mittels einer 5 kW-Metallhalogenidlampe im Abstand von 110 cm unter einem 13-stufigen Belichtungskeil mit Dichteinkrementen von 0,15 belichtet, auf den, soweit angegeben, zusätzlich ein Silberfilm mit gleichmäßiger Schwärzung (Dichte 1,57) und gleichmäßiger Absorption über den wirksamen Spektralbereich als Graufilter montiert wurde. Um die Empfindlichkeit der Folien im sichtbaren Licht zu testen, wurden auf den Belichtungskeil jeweils 3 mm starke Kantenfilter der Firma Schott mit der in der Tabelle angegebenen Kantendurchlässigkeit montiert. Nach einer Belichtung von 40 Sekunden wurden die Folien eine Minute auf 100° C erwärmt. Anschließend wurden sie mit einem Entwickler folgender Zusammensetzung im Schaukelbad 1 Minute entwickelt, vorsichtig überwischt und mit Wasser abgespült:
8,5 Gt Natriummetasilikat x _{9 H₂O,}
0,8 Gt NaOH und
1,5 Gt Na₂B₄O₇ x 10 H₂O in
89,2 Gt vollentsalztem Wasser.

**Tabelle 1**

| Schichtgewicht | Graufilter | Kantenfilter | Keilstufen | Optische Dichte |
|---|---|---|---|---|
| 2,0 g/m² | ja | - | 6 | 2,3 |
| | nein | 455 | 7 | |
| 2,5 g/m² | ja | - | 5 | 2,8 |
| | nein | 455 | 6 | |
| 3,2 g/m² | ja | - | 5 | 3,4 |
| | nein | 455 | 6 | |

Die optischen Dichten wurden an einem Photovolt-Densitometer bei 395 nm gemessen. Die erhaltenen positiven Testbilder können als photographische Vorlage anstelle einer entsprechenden Silberfilm-Vorlage zum Belichten von handelsüblichen vorsensibilisierten Positiv- und Negativ-Druckplattn verwendet werden. Man erhält bei der Normalbelichtung ein sauberes Bild der Vorlage auf der Druckplatte.

### Beispiel 2 (Vergleichsbeispiel)

Auf den in Beispiel 1 angegebenen Schichtträger wurde eine Lösung folgender Zusammensetzung so aufgeschleudert, daß ein Schichtgewicht von 2,5 g/m² erhalten wurde:
2,87 Gt der in Beispiel 1 angegebenen Terpolymerisatlösung,
0,7 Gt Trimethylolpropantriacrylat,
0,04 Gt Eosin,
0,03 Gt des in Beispiel 1 angegebenen s-Triazins,
0,06 Gt 9-Phenylacridin,
0,2 Gt des in Beispiel 1 angegebenen Oxdiazols und
0,2 Gt des in Beispiel 1 angegebenen Dibenzalacetons in
20,0 Gt Propylenglykolmonomethylether.

Die Folie wurde wie in Beispiel 1 verarbeitet. Nach 40 Sekunden Belichtung wurde die folgende Anzahl vollvernetzter Keilstufen erhalten:

| Graufilter | Kantenfilter | Stufen |
|---|---|---|
| ja | - | 3 |
| nein | 455 | 2 |

### Beispiel 3

Auf eine mit Haftvermittler beschichtete biaxial verstreckte 75 µm dicke Polyethylenterephthalat-Folie wurde die Beschichtungslösung aus Beispiel 1 so aufgeschleudert, daß nach dem Trocknen ein Schichtgewicht von 2,5 g/m² erhalten wurde. Die Folie wurde in gleicher Weise wie in Beispiel 1 verarbeitet. Nach 40 Sekunden Belichtungszeit wurden unter dem Graufilter 7 und unter dem Kantenfilter 455 nm 8 Keilstufen erhalten.

### Beispiel 4

Die Beschichtungslösung aus Beispiel 1 wurde auf eine biaxial verstreckte 35 µm dicke Polyethylenterephthalatfolie so aufgeschleudert, daß nach dem Trocknen ein Schichtgewicht von 3 g/m² erhalten wurde. Anschließend wurde die Schicht bei 115 °C mit 1,5 m je Minute auf eine handelsübliche vorsensibilisierte Positiv-Druckplatte, welche einen 1,2-Naphthochinondiazidsulfonsäureester als lichtempfindliche Substanz enthält, laminiert. Die Druckplatte wurde wie in Beispiel 1 beschrieben unter einer Negativ-Vorlage und dem dort angeführten Silberfilm 40 Sekunden belichtet. Nach einer Minute Tempern bei 100 °C wurde die Deckfolie abgezogen. Auf der Druckplatte verblieben die durchgehärteten Bildanteile der photopolymerisierbaren Schicht als UV-undurchlässige, positive Bildmaske, während die unbelichteten Bereiche an der Deckfolie hafteten. Nach einer zweiten sich anschließenden Belichtung von 30 Sekunden ohne Vorlage mit UV-Licht und Ablösen der löslichen Schichtanteile der Chinondiazidschicht mit einer wäßrig-alkalischen Lösung erhielt man eine, bezogen auf das Original, positive Druckplatte. Sie lieferte 150.000 saubere Drucke. Die abgezogene Folie kann als Positivvorlage weiter verwendet werden.

### Beispiel 5

Auf den in Beispiel 1 angegebenen Schichtträger wurde unter gleichen Bedingungen wie dort eine Lösung folgender Zusammensetzung mit einem Schichtgewicht von 2 g/m² aufgeschleudert.
2,87 Gt der in Beispiel 1 angegebenen Terpolymerisatlösung,
4,5 Gt der in Beispiel 1 angegebenen Monomerlösung,
0,05 Gt des in Beispiel 1 angegebenen s-Triazins,
0,05 Gt 9-Phenylacridin,
0,04 Gt Eosin,
0,4 Gt des in Beispiel 1 angegebenen Oxdiazols,
0,3 Gt des in Beispiel 1 angegebenen Dibenzalacetons und
0,2 Gt Tris-(4-dimethylaminophenyl)-methan in
20,0 Gt Propylenglykolmonomethylether.

Die beschichtete Folie wurde wie in Beispiel 1 getrocknet und mit einer Deckschicht versehen. Nach 30 Sekunden Belichten und Entwickeln wie im Beispiel 1 erhielt man mit Graufilter 3 und mit Kantenfilter 5 vollvernetzte Keilstufen.

Durch eine Belichtung von 10 Sekunden ohne Vorlage mittels einer 5 kW-Metallhalogenidlampe erhielt man eine Farbvertiefung. Die Extinktionskurve zeigte eine Dichte von mindestens 3,2 im Spektralbereich von 300 - 550 nm. Unter einer solchen Vorlage wurden handelsübliche Negativ-Flachdruckplatten mit Diazoschichten und eine handelsübliche Photopolymer-Flachdruckplatte belichtet. Es wurden grundfreie, in der Druckmaschine nicht tonende Druckplatten erhalten.

### Beispiel 6

Vier lichtempfindliche Beschichtungslösungen in den Grundfarben Blaugrün, Gelb, Purpur und Schwarz der nachstehend angegebenen Zusammensetzung in Gt wurden hergestellt:

| | Blaugrün | Gelb | Purpur | Schwarz |
|---|---|---|---|---|
| 2-Methoxy-ethanol | 41,00 | 41,00 | 46,50 | 41,00 |
| Butanon | 41,00 | 40,99 | 46,48 | 41,00 |
| Butyrolacton | 10,00 | 10,00 | - | 10,00 |
| Dimethylphthalat | 0,75 | 0,75 | 0,88 | 0,75 |
| Dibutylphthalat | 0,25 | 0,25 | - | 0,25 |
| p-Toluolsulfonsäure | - | - | 0,18 | 0,35 |
| Scripset 540 ¹⁾ | 3,33 | 2,60 | 3,15 | 3,71 |
| Scripset 550 ²⁾ | 1,17 | - | - | - |
| hydrolysiertes Scripset 540 | - | - | 0,67 | - |
| SMA 2625 ³⁾ | - | 2,02 | - | - |
| Diazoniumsalz-Polykondensationsprodukt ⁴⁾ | 1,33 | 1,35 | 0,70 | 2,00 |
| Phthalocyaninblau | 1,17 | - | - | - |
| gelbes Pigment | - | 1,04 | - | - |
| Purpurpigment | - | - | 1,44 | - |
| schwarzes Pigment | - | - | - | 0,94 |
| optische Dichte | 1,1 | 0,9 | 1,2 | 1,5 |

| | | | | |
|---|---|---|---|---|
| ¹⁾ Styrol-Monoisobutylmaleinat-Copolymeres; SZ 400 | | | | |
| ²⁾ Styrol-Monoisobutylmaleinat-Copolymeres; SZ 175; MG 45.000 | | | | |
| ³⁾ Styrol-Maleinsäureanhydrid-Copolymeres; MG 1900; SZ 220 | | | | |
| ⁴⁾ aus 1 mol 3-Methoxy-diphenylamin-4-diazoniumsalz und 1 mol 4,4'-Bis-methoxymethyl-diphenylether, ausgefällt als Mesitylensulfonat | | | | |

Das Farbpigment wurde der Lösung jeweils in Form einer Dispersion aus Butanon, Scripset 540 und dem entsprechenden Pigment zugegeben. Die Lösungen wurden einzeln auf 75 µm dicke Polyesterfolien (Melinex 516) als temporäre Träger so aufgebracht und getrocknet, daß sich die erforderliche optische Dichte ergab. Die Schichtgewichte betrugen ungefähr 1,3 g/m² für Blaugrün, 0,9 g/m² für Gelb, 1,8 g/m² für Purpur und 1,2 g/m² für Schwarz. Eine Adhäsivlösung aus 78 Gt n-Butylacetat, 1 Gt Resoflex R-296 (polymerer Weichmacher) und 21 Gt Mowilith 25 (Polyvinylacetat; MG 100.000) wurde auf die lichtempfindliche Schicht aufgebracht und zu einer Haftschicht mit einem Schichtgewicht von 12 g/m² getrocknet. Auf die Rückseiten der Polyesterfolien wurde die lichtempfindliche Mischung aus Beispiel 1 zu einem Schichtgewicht von 3 g/m² aufgebracht. Nach dem Auftragen einer Deckschicht aus Polyvinylalkohol auf die Photopolymerschicht wurde das Material mit der gelben Schicht mit seiner Adhäsivschicht bei 80° C auf ein 180 µm dickes Polyesterempfangsblatt (Melinex 3020) laminiert. Die photopolymerisierbare Schicht wurde anschließend entsprechend den gelben Bildanteilen digital mit Laserlicht der Wellenlängen 488 bzw. 514 nm bebildert oder unter einem den gelben Bildanteilen entsprechenden Farbauszug belichtet. Das belichtete Material wurde bei 100 °C eine Minute getempert und anschließend mit dem Entwickler aus Beispiel 1 im Schaukelbad 60 Sekunden entwickelt.

Die nicht belichteten Bereiche wurden abgelöst, und zurück blieb eine UV-Licht absorbierende Photomaske für die darunterliegende lichtempfindliche Diazoschicht. Durch anschließende Belichtung ohne Vorlage mit Licht im Spektralbereich unterhalb 450 nm wurde ein negatives Abbild der darüberliegenden Photomaske erzeugt. Der temporäre Träger wurde abgezogen, und das Empfangsblatt mit der belichteten gelben Schicht wurde bei 27 °C 15 Sekunden in den folgenden Entwickler getaucht:
89,264 Gt Wasser,
0,269 Gt Mononatriumphosphat,
2,230 Gt Trinatriumphosphat x 12 H₂O,
8,237 Gt Natriumtetradecylsulfat.

Die nichtbelichteten gelben Bereiche wurden beim Entwickeln abgelöst, die belichteten Bereiche blieben zurück. Die Haftschicht wurde durch die beiden Entwickler nicht angegriffen. Nach dieser Behandlung wurde das bebilderte Material abgespült und getrocknet. Auf die gleiche Weise wurden nacheinander die Folien mit den Farben Purpur, Blaugrün und Schwarz auf das vorhergehende Teilfarbenbild laminiert und verarbeitet. Es wurde schließlich ein Vierfarbenbild erhalten, das eine Wiedergabe des Originals ist, von dem die Farbauszüge hergestellt wurden.

### Beispiel 7

Es wurden vier positiv arbeitende lichtempfindliche Lösungen in den Farben Blaugrün, Gelb, Purpur und Schwarz der nachstehenden Zusammensetzung hergestellt:

| | Blaugrün | Gelb | Purpur | Schwarz |
|---|---|---|---|---|
| Diacetonalkohol | - | 11,7 | - | - |
| Butanon | 35,52 | 34,45 | 24,23 | 38,62 |
| Butyrolacton | 22,60 | 11,15 | 24,04 | 5,74 |
| Propylenglykolmonomethylether | 34,76 | 35,21 | 44,94 | 48,34 |
| Scripset 540 | 1,60 | 2,01 | 2,15 | 2,39 |
| SMA 2625 | 1,74 | 1,17 | - | 0,60 |
| Polyvinylbutyral | 0,58 | 0,59 | 0,67 | 0,30 |
| (Tg 65 °C) | | | | |
| Ester aus Bis-(3-benzoyl-4,5,6-trihydroxyphenyl)methan und 2-Diazo-1-naphthol-5-sulfonsäure | 2,09 | 2,58 | 2,81 | 2,72 |
| Phthalocyaninblau | 1,11 | - | - | - |
| gelbes Pigment | - | 1,08 | - | - |
| Purpurpigment | - | - | 1,15 | - |
| schwarzes Pigment | - | - | - | 1,29 |
| optische Dichte | 1,2 | 1,0 | 1,4 | 1,6 |

Das Farbpigment wurde der Lösung jeweils in Form einer Dispersion aus Butanon, Scripset 540 und dem entsprechenden Pigment zugegeben. Die Lösungen wurden einzeln auf 75 µm dicke Polyesterfolien als temporäre Träger so aufgebracht und getrocknet, daß sich die erforderliche optische Dichte ergab. Die Schichtgewichte betrugen ungefähr 1,23 g/m² für Blaugrün, 1,4 g/m² für Gelb, 2,0 g/m² für Purpur und 1,0 g/m² für Schwarz. Die Adhäsivlösung aus 70 Gt Isopropylacetat und 30 Gt Polyvinylacetat (MG: 110.000) wurde auf die lichtempfindliche Schicht aufgebracht und zu einem Schichtgewicht von 8 g/m² getrocknet.

Auf die Rückseiten der Polyesterfolien wurde die lichtempfindliche Mischung aus Beispiel 1 zu einem Schichtgewicht von 3 g/m² aufgebracht. Nach dem Auftragen einer Deckschicht aus Polyvinylalkohol auf die Photopolymerschicht wurde die gelbe Farbprüffolie mit ihrer Haftschicht bei 80 °C auf ein 180 µm dickes Polyesterempfangsblatt (Melinex 3020) laminiert. Die Schicht wurde anschließend entsprechend den gelben Bildanteilen digital mit Laserlicht der Wellenlänge 488 bzw. 514 nm bebildert oder im Kontakt unter dem den gelben Bildanteilen entsprechenden Farbauszug belichtet. Das belichtete Material wurde bei 100 °C eine Minute getempert und anschließend mit dem Entwickler aus Beispiel 1 im Schaukelbad 60 Sekunden entwickelt.

Die nicht belichteten Bereiche wurden abgelöst, und zurück blieb eine UV-Licht absorbierende Photomaske für die darunterliegende lichtempfindliche Chinondiazidschicht. Durch anschließende Belichtung ohne Vorlage mit aktinischer Strahlung im Spektralbereich unterhalb 450 nm wurde ein positives Abbild der darüberliegenden Photomaske erzeugt. Der temporäre Träger wurde abgezogen, und das Empfangsblatt mit der belichteten gelben Schicht wurde bei 27 °C 15 Sekunden in den in Beispiel 6 angegebenen Entwickler getaucht.

Die belichteten gelben Bereiche wurden beim Entwickeln abgelöst, die nichtbelichteten Bereiche blieben zurück. Die Haftschicht wurde durch die beiden Entwickler nicht angegriffen. Nach dieser Behandlung wurde das bebilderte Material abgespült und getrocknet. Auf die gleiche Weise wurden nacheinander die Folien mit den Farben Purpur, Blaugrün und Schwarz auf das vorhergehende Teilfarbenbild laminiert und verarbeitet. Nach einer abschließenden Belichtung ohne Vorlage mit Licht im Spektralbereich unterhalb 450 nm wurde ein Vierfarbenbild erhalten, das den Farbeindruck des Originals simuliert.

## Patentansprüche

1. Photopolymerisierbares Gemisch, das als wesentliche Bestandteile
a) ein polymeres Bindemittel,
b) einen Acryl- oder Alkacrylsäureester eines mehrwertigen Alkohols, der mindestens eine photooxydierbare Gruppe enthält, und
c) eine Verbindung oder eine Verbindungskombination enthält, die unter Einwirkung von Licht im Spektralbereich von 450 bis 650 nm die Polymerisation der Verbindung (b) zu initiieren vermag,
dadurch gekennzeichnet, daß das Gemisch ferner mindestens eine Verbindung (d) enthält, die Licht im Bereich unterhalb 450 nm absorbiert oder die bei Belichtung in dem Gemisch eine Verbindung mit einer derartigen Lichtabsorption bildet, wobei die Konzentration der Verbindung (d) so bemessen ist, daß die optische Dichte des belichteten Gemischs in diesem Bereich bei einer Schichtdicke von 2 µm mindestens 2,0 beträgt, und daß bei dünneren Schichten die optische Dichte der Schicht nicht kleiner als 2 wird.

2. Photopolymerisierbares Gemisch nach Anspruch 1, dadurch gekennzeichnet, daß die photooxydierbare Gruppe eine Amino-, Harnstoff-, Thio-, oder Enolgruppe ist.

3. Photopolymerisierbares Gemisch nach Anspruch 1, dadurch gekennzeichnet, daß es als Verbindung (c) einen photoreduzierbaren Farbstoff enthält.

4. Photopolymerisierbares Gemisch nach Anspruch 3, dadurch gekennzeichnet, daß der photoreduzierbare Farbstoff ein Xanthen-, Thiazin-, Pyronin-, Porphyrin- oder Acridinfarbstoff ist.

5. Photopolymerisierbares Gemisch nach Anspruch 3, dadurch gekennzeichnet, daß es als weitere Verbindung (c) eine Verbindung enthält, die bei Belichtung Radikale bildet, die die Polymerisation des Acryl- oder Alkacrylsäureesters (b) einzuleiten vermögen.

6. Photopolymerisierbares Gemisch nach Anspruch 1, dadurch gekennzeichnet, daß das Bindemittel wasserunlöslich, aber in wäßrig-alkalischen Lösungen löslich ist.

7. Photopolymerisierbares Gemisch nach Anspruch 1, dadurch gekennzeichnet, daß es 20 bis 85 Gew.-% Bindemittel (a), 10 bis 75 Gew.-% Acryl- oder Alkacrylsäureester (b), 0,05 bis 20 Gew.-% lichtempfindliche Polymerisationsinitiatoren (c) und 5 bis 40 Gew.-% Licht absorbierende Verbindung (d) enthält.

8. Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß einem der Ansprüche 1 bis 7 besteht.

9. Aufzeichnungsmaterial nach Anspruch 8, dadurch gekennzeichnet, daß der Schichtträger transparent ist.

10. Aufzeichnungsmaterial nach Anspruch 9, dadurch gekennzeichnet, daß es auf der Rückseite des Schichtträgers eine zusätzliche lichtempfindliche Schicht trägt, die für Licht im Spektralbereich unterhalb 450 nm empfindlich ist.

11. Aufzeichnungsmaterial nach Anspruch 10, dadurch gekennzeichnet, daß die zusätzliche lichtempfindliche Schicht einen Farbstoff oder ein Pigment in einer Grundfarbe des Mehrfarbendrucks enthält und von dem Schichtträger auf ein Empfangsblatt übertragbar ist.

12. Aufzeichnungsmaterial nach Anspruch 8, dadurch gekennzeichnet, daß unterhalb der photopolymerisierbaren Schicht eine weitere, für Licht im Spektralbereich unterhalb 450 nm empfindliche Schicht liegt, die in einer Entwicklerlösung für die photopolymerisierbare Schicht unlöslich ist.

13. Aufzeichnungsmaterial nach Anspruch 8, dadurch gekennzeichnet, daß die photopolymerisierbare Schicht mit einer für Luftsauerstoff wenig durchlässigen Deckschicht abgedeckt ist.

14. Verfahren zur Herstellung von Kopien mittels eines Aufzeichungsmaterials gemäß Anspruch 8, dadurch gekennzeichnet, daß man die photopolymerisierbare Schicht mit Licht einer Wellenlänge oberhalb 450 nm bildmäßig belichtet, die Nichtbildstellen mit einem Entwickler auswäscht und das erhaltene Negativbild als Kopiervorlage für die Belichtung einer lichtempfindlichen Schicht mit Licht im Spektralbereich unterhalb 450 nm einsetzt.

15. Farbprüfverfahren für den Mehrfarbendruck, dadurch gekennzeichnet, daß man
A) die photopolymerisierbare Schicht eines lichtempfindlichen Aufzeichnungsmaterials gemäß Anspruch 11 bildmäßig mit Licht einer Wellenlänge oberhalb 450 nm bildmäßig belichtet,
B) vor oder nach dem Belichten das Material mit der zusätzlichen lichtempfindlichen Schicht auf ein Empfangsblatt laminiert,
C) die unbelichteten Bereiche der photopolymerisierbaren Schicht auswäscht,
D) die zusätzliche lichtempfindliche Schicht durch den transparenten Schichtträger hindurch unter der entwickelten photopolymerisierbaren Schicht als Kopiervorlage mit Licht einer Wellenlänge unterhalb 450 nm belichtet,
E) den Schichtträger mit der entwickelten photopolymerisierbaren Schicht von der zusätzlichen lichtempfindlichen Schicht abzieht,
F) die letztere durch Auswaschen der Nichtbildstellen entwickelt
und die Schritte (A) bis (F) mit mindestens einem lichtempfindlichen Aufzeichnungsmaterial, dessen zusätzliche lichtempfindliche Schicht in einer anderen Grundfarbe eingefärbt ist, wiederholt.

## Claims

1. A photopolymerizable mixture containing, as essential constituents,
a) a polymeric binder,
b) an acrylate or alkacrylate or a polyhydric alcohol possessing at least one photooxidizable group, and
c) a compound or a combination of compounds, which under the action of light in the spectral region of 450 to 650 nm is capable of initiating the polymerization of compound (b),
characterized in that it furthermore contains at least one compound (d), which absorbs light in the region below 450 nm or which, upon exposure, forms a compound in the mixture which has such an absorption range, whereby the concentration of said compound (d) is adjusted such that the optical density of the exposed mixture in this range is at least 2.0 at a layer thickness of 2 µm, and that in the case of thinner layers the optical density of the layer does not fall below a value of 2.

2. A photopolymerizable mixture as claimed in claim 1, characterized in that the photooxidizable group is an amino, urea, thio or enol group.

3. A photopolymerizable mixture as claimed in claim 1, characterized in that it contains a photoreducible dye as compound (c).

4. A photopolymerizable mixture as claimed in claim 3, characterized in that the photoreducible dye is a xanthene, thiazine, pyronine, phorphyrine or acridine dye.

5. A photopolymerizable mixture as claimed in claim 3, characterized in that it contains, as a further compound (c), a compound which upon exposure forms free radicals which are capable or initiating the polymerization of the acrylate or alkacrylate (b).

6. A photopolymerizable mixture as claimed in claim 1, characterized in that the binder is insoluble in water, but soluble in aqueous-alkaline solutions.

7. A photopolymerizable mixture as claimed in claim 1, characterized in that it contains 20 to 85 % by weight of binder (a), 10 to 75 % by weight of acrylate or alkacrylate (b), 0.05 to 20 % by weight of photosensitive polymerization initiators (c) and 5 to 40 % by weight of light-absorbing compound (d).

8. A photopolymerizable recording material comprising a layer support and a photopolymerizable layer, characterized in that said photopolymerizable layer is comprised of a mixture as claimed in any of claims 1 to 7.

9. A recording material as claimed in claim 8, characterized in that the layer support is transparent.

10. A recording material as claimed in claim 9, characterized in that it comprises an additional photosensitive layer applied to the rear surface of the layer support and sensitive to light in the spectral region below 450 nm.

11. A recording material as claimed in claim 10, characterized in that the additional photosensitive layer contains a dye or pigment having one of the basic colors of the multicolor print and that it can be transferred from the layer support to a receiving sheet.

12. A recording material as claimed in claim 8, characterized in that below the photopolymerizable layer another layer is provided on the support, which layer is sensitive to light in the spectral region below 450 nm and insoluble in the developer solution used for the photopolymerizable layer.

13. A recording material as claimed in claim 8, characterized in that the photopolymerizable layer is protected by a cover layer possessing low permeability to atmospheric oxygen.

14. Process for the production of copies by means of a recording material as claimed in claim 8, characterized in that the photopolymerizable layer is imagewise exposed using light of a wavelength above 450 nm, the non-image areas are washed out with a developer, and the resulting negative image is used as a master for exposing a photosensitive layer to light in the spectral range below 450 nm.

15. Color proofing method for multicolor printing, characterized in that
A) the photopolymerizable layer of a photosensitive material as claimed in claim 11 is exposed imagewise using light of a wavelength above 450 nm;
B) the material is laminated with the additional photosensitive layer, to a receiving sheet, either before or after the exposure step;
C) the unexposed portions of the photopolymerizable layer are washed out;
D) the additional photosensitive layer is exposed through the transparent layer support and through the developed photopolymerizable layer serving as master, using light of a wavelength below 450 nm;
E) the layer support, together with the developed photopolymerizable layer, is peeled off the additional photosensitive layer;
F) the latter is developed by washing out the non-image areas, and
steps A) to F) are repeated with at least one further photosensitive recording material whose additional photosensitive layer is dyed with another basic color.

## Revendications

1. Composition photopolymérisable, qui contient, en tant que composants essentiels :
a) un liant polymère ;
b) un acrylate ou alkacrylate d'un alcool polyhydroxylé, qui contient au moins un groupe photo-oxydadable ; et
c) un composé ou une association de composés capable, sous l'effet d'une lumière dans la région spectrale de 450 à 650 nm, d'amorcer la polymérisation du composé (b) ;
caractérisée en ce que le mélange contient en outre au moins un composé (d) qui adsorbe la lumière dans la région au-dessous de 450 nm ou qui forme dans la composition, lors de l'insolation, un composé présentant une telle adsorption de la lumière, la concentration du composé (d) étant choisie de manière que la densité optique de la composition insolée s'élève à au moins 2,0 dans cette région, pour une épaisseur de couche de 2 µm, et en ce que, dans le cas de couches plus minces, la densité optique de la couche n'est pas inférieure à 2.

2. Composition photopolymérisable selon la revendication 1, caractérisée en ce que le groupe photo-oxydable est un groupe amino, urée, thio ou énol.

3. Composition photopolymérisable selon la revendication 1, caractérisée en ce qu'elle contient, en tant que composé (c), un colorant photoréductible.

4. Composition photopolymérisable selon la revendication 3, caractérisée en ce que le colorant photoréductible est un colorant xanthène, thiazine, pyronine, porphyrine ou acridine.

5. Composition photopolymérisable selon la revendication 3, caractérisée en ce qu'elle contient, en tant qu'autre composé (c), un composé qui forme lors de l'insolation des radicaux libres qui sont capables d'amorcer la polymérisation de l'ester acrylique ou alkacrylique (b).

6. Composition photopolymérisable selon la revendication 1, caractérisée en ce que le liant est insoluble dans l'eau, mais soluble dans des solutions aqueuses-alcalines.

7. Composition photopolymérisable selon la revendication 1, caractérisée en ce qu'elle contient de 20 à 85 % en poids de liant (a), de 10 à 75 % en poids d'ester acrylique ou alkacrylique b), de 0,05 à 20 % en poids d'initiateurs de polymérisation photosensibles (c) et de 5 à 40 % en poids de composé (d) adsorbant la lumière.

8. Matériau de reprographie photopolymérisable comportant un support de couche et une couche photopolymérisable, caractérisé en ce que la couche photopolymérisable est constituée d'une composition selon l'une des revendications 1 à 7.

9. Matériau de reprographie selon la revendication 8, caractérisé en ce que le support de couche est transparent.

10. Matériau de reprographie selon la revendication 9, caractérisé en ce qu'il porte, sur l'envers du support de couche, une couche photosensible supplémentaire qui est sensible à la lumière dans la région spectrale au-dessous de 450 nm.

11. Matériau de reprographie selon la, revendication 10, caractérisé en ce que la couche photosensible supplémentaire contient un colorant ou un pigment d'une couleur fondamentale de l'impression polychrome, et est transférable, du support de couche, sur une feuille réceptrice.

12. Matériau de reprographie selon la, revendication 8, caractérisé en ce que, au-dessous de la couche photopolymérisable, se trouve une autre couche sensible à la lumière dans la région spectrale au-dessous de 450 nm, qui est insoluble dans une solution de développement pour la couche photopolymérisable.

13. Matériau de reprographie selon la revendication 8, caractérisé en ce que la couche photopolymérisable est recouverte d'une couche de recouvrement peu perméable à l'oxygène de l'air.

14. Procédé pour la production de copies au moyen d'un matériau de reprographie selon la revendication 8, caractérisé en ce que l'on soumet à une insolation selon l'image la couche photopolymérisable, avec de la lumière d'une longueur d'onde supérieure à 450 nm, on élimine par lavage avec un révélateur les zones de non image, et l'image négative obtenue est utilisée comme original à copier pour l'insolation d'une couche photosensible avec de la lumière dans la région spectrale au-dessous de 450 nm.

15. Procédé d'épreuve couleur pour l'impression polychrome, caractérisé en ce que ;
A) la couche photopolymérisable d'un matériau de reprographie photosensible selon la revendication 11 est insolée selon l'image avec de la lumière d'une longueur d'onde supérieure à 450 nm ;
B) avant ou après l'insolation, le matériau est appliqué par laminage, avec la couche photosensible supplémentaire sur une feuille réceptrice ;
C) les parties non insolées de la couche photopolymérisables sont éliminées par lavage ;
D) la couche photosensible supplémentaire est insolée, à travers le support de couche transparent, sous la couche photopolymérisable développée, en tant qu'original à copier, avec de la lumière d'une longueur d'onde inférieure à 450 nm ;
E) on retire le support de couche, avec la couche photopolymérisable développée, de la couche photosensible supplémentaire ;
F) on développe cette dernière par élimination par lavage des zones de non image,
et on répète les étapes (A) à (F) avec au moins un matériau de reprographie photosensible dont la couche photosensible supplémentaire est colorée en une autre couleur fondamentale.
